(19)

**Europäisches Patentamt**

**European Patent Office**

**Office européen des brevets**

(11) **EP 4 633 061 A1**

(12) **EUROPEAN PATENT APPLICATION**

(43) Date of publication:
**15.10.2025 Bulletin 2025/42**

(21) Application number: **24315158.6**

(22) Date of filing: **12.04.2024**

(51) International Patent Classification (IPC):
**H04B 10/116** (2013.01)   **H04B 10/50** (2013.01)
**H01L 27/15** (2006.01)   **H01L 33/38** (2010.01)
**H01L 33/20** (2010.01)   **H01L 33/44** (2010.01)

(52) Cooperative Patent Classification (CPC):
**H04B 10/116; H10H 20/8314; H10H 29/142;**
**H10H 20/84**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Commissariat à l'Energie Atomique et aux Energies Alternatives**
**75015 Paris (FR)**

(72) Inventors:
• **El Badaoui, Sultan**
**38054 GRENOBLE CEDEX 09 (FR)**
• **Le Maitre, Patrick**
**38054 GRENOBLE CEDEX 09 (FR)**
• **Cibie, Anthony**
**38054 GRENOBLE CEDEX 09 (FR)**
• **Simon, Julia**
**38054 GRENOBLE CEDEX 09 (FR)**

(74) Representative: **Cabinet Beaumont**
**4, Place Robert Schuman**
**B.P. 1529**
**38025 Grenoble Cedex 1 (FR)**

(54) **OPTOELECTRONIC DEVICE FOR OPTICAL COMMUNICATION**

(57)    An optoelectronic device (100) configured to convert an electrical digital information signal into a light digital information signal, comprising:
- a semiconductor stack (120) including a first doped semiconductor portion (122) and a second doped semiconductor portion (124) forming together a PN junction;
- a first electrode coupled to the first doped semiconductor portion, a second electrode coupled to the second doped semiconductor portion, and an electrostatic gate (140) arranged against sidewalls of the semiconductor stack;
- a first driver circuit (160) comprising an input (162) configured to receive a first part of the electrical digital information signal and an output (164) coupled to the electrostatic gate and onto which, for each bit of the first part of the electrical digital information signal, a voltage is supplied, the value of which depends at least in part on that of said bit.

**Fig. 1**

EP 4 633 061 A1

**Description**

Technical field

The present disclosure relates generally to optical communication field using optoelectronic devices such as μLEDs (micro Light-Emitting Diodes).

Background art

It is known to use μLEDs for optical communication such as Visible Light Communication (VLC), Light Fidelity (Li-Fi), Under-Water Optical Communication (UWOC), Chip-to-Chip (C2C) optical communication, etc. A μLED is a microelectronic device that emits light when an electrical current flows through it. The optical power obtained at the output of the μLED depends on the value of the current injected through it. Thus, modulating the current injected through a μLED will lead to a modulation of the optical power emitted by the μLED.

In optical communication field, it is known to use NRZ (Non-Return-to-Zero) coding associated with an OOK (On-Off Keying) modulation, named NRZ-OOK modulation. The principle of such modulation used with a μLED is to send digital data, corresponding to the information signal intended to be optically transmitted by the μLED and which is coded according to an NRZ scheme, to a driver which converts the digital signal into a current, or voltage, at a level suitable for the μLED. For example, the μLED may emit light when the information to transmit optically corresponds to a bit having a first value (e.g. '1') and the μLED may not emit light when the information to transmit optically corresponds to a bit having a second value (e.g. '0'). In another configuration, the μLED may also always emit light, but one of the states '0' or '1' may have a higher optical power compared to the other state.

In order to increase the data rate of the μLED, i.e the number of bits transmitted per second, it is possible to use a multilevel modulation instead of NRZ-OOK modulation.

According to the Nyquist theorem, a maximum data rate $DR_{max}$ than can be achieved for a signal with a given bandwidth and a given number of modulation levels is:

[Math 1]

$$DR_{max} = 2 \; x \; Bandwidth \; x \; log_2(M)$$

with M corresponding to the number of discrete levels of the signal.

The above equation shows that it is possible to increase the achievable data rate of a system by increasing the number of modulation levels. An example of multilevel modulation is PAM-N (Pulse-Amplitude Modulation-N), where N is the number of modulation levels, which it could be 4, 8 or more.

However, increasing the number of modulation levels decreases the separation between the different levels, i.e. the difference of optical power between two successive levels, thus decreasing the Signal-to-Noise Ratio (SNR) and increasing the Bit-Error-Rate (BER) which is the quantity of transmitted bits that are received incorrectly and is used as a measure of signal integrity. This is why the SNR is also an important factor in determining the achievable data rate of a signal. The Shannon theorem states that the maximum achievable data rate $DR_{max}$ of a signal in function of given bandwidth and SNR is:

[Math 2]

$$DR_{max} = Bandwidth \; x \; log_2(1 + SNR)$$

For example, with a four-levels PAM (PAM-4) signal, the amplitude difference between two successive levels is equal to a third of the amplitude between the two levels of OOK signal. In this case, this difference decreases the SNR by 9.54 dB; and thus increases the BER.

In addition to the data rate, another factor that should be considered for the final application is the electronics complexity. Even though NRZ-OOK is the format that carry the less information at a given operation speed or a given clock period, i.e. the lowest data rate for a given speed, it is also the simplest, meaning that it requires very simple electronics to operate. Other modulation formats having higher data rates for a given speed or a given clock period, such as PAM-N, require more complex electronic circuits, leading to an increase in both power consumption and cost of the final device. For example, using standard PAM-4 modulation with a μLED requires a DAC (Digital-to-Analog Converter) and a linear driver to convert the input digital signal into a current or voltage at a level suitable for the μLED.

The documents A. Samani et al., "A silicon photonic PAM-4 modulator based on dual-parallel Mach-Zehnder interferometers", IEEE Photonics J., vol. 8, no. 1, pp. 1-10, 2016, and L. Deniel et al., "DAC-less PAM-4 generation in the O-band using a silicon Mach-Zehnder modulator," Opt. Express, vol. 27, no. 7, p. 9740, 2019, disclose DAC-less PAM communication devices. In these devices, energy is saved because PAM is achieved without the need for DAC. However, these devices use separate Mach-Zehnder Interferometers (MZI) to achieve the PAM-4 signal in silicon photonics, involving larger footprint for photonics circuits.

Summary of Invention

There is a need to propose an alternative solution to obtain the advantages of multilevel modulation, without at least a part of the drawbacks of the known optoelectronic devices.

One embodiment addresses all or some of these drawbacks and proposes an optoelectronic device configured to convert an electrical digital information signal into a light digital information signal, comprising at least:

- a semiconductor stack including at least a first doped semiconductor portion of a first conductivity type and a second doped semiconductor portion of a second conductivity type forming together a PN junction;

- a first electrode coupled to the first doped semiconductor portion, a second electrode coupled to the second doped semiconductor portion, and an electrostatic gate arranged against sidewalls of at least a part of the semiconductor stack;

- a first driver circuit comprising an input configured to receive at least a first part of the electrical digital information signal and an output coupled to the electrostatic gate and onto which, for each bit of the first part of the electrical digital information signal, a voltage is supplied, the value of which depends at least in part on that of said bit.

According to a particular embodiment, the optoelectronic device further comprises:

- a second driver circuit comprising an input configured to receive a second part of the electrical digital information signal, and an output coupled to the second electrode and onto which, for each bit of the second part of the electrical digital information signal, a voltage is supplied, the value of which depends at least in part on that of said bit;

- an encoder configured to receive in an input the electrical digital information signal, to supply the first part of the electrical digital information signal to the input of the first driver circuit and to supply the second part of the electrical digital information signal to the input of the second driver circuit.

According to a particular embodiment, the electrostatic gate comprises at least first and second distinct parts which are decoupled one to the other, the first part of the electrostatic gate facing at least one first side of the semiconductor stack and being coupled to the output of the first driver circuit, and the second part of the electrostatic gate facing at least one second side of semiconductor stack, and the optoelectronic device further comprises:

- a second driver circuit comprising an input configured to receive a second part of the electrical digital information signal, and an output coupled to the second part of the electrostatic gate and onto which, for each bit of the second part of the electrical digital information signal, a voltage is supplied, the value of which depends at least in part on said bit;

- an encoder configured to receive in an input the electrical digital information signal, to supply the first part of the electrical digital information signal to the input of the first driver circuit and to supply the second part of the electrical digital information signal to the input of the second driver circuit.

According to a particular embodiment, the encoder is configured to encode the first and second parts of electrical digital information signal such that said first part comprises the odd bits of the electrical digital information signal and that said second part comprises the even bits of the electrical digital information signal, or such that said first part comprises the even bits of the electrical digital information signal and that said second part comprises the odd bits of the electrical digital information signal.

According to a particular embodiment, the encoder is configured to encode the first and second parts of the electrical digital information signal from the electrical digital information signal which is coded and modulated according to a PAM-4 modulation.

According to a particular embodiment, the encoder is configured to encode the first and second parts of the electrical digital information signal from the electrical digital information signal which is coded and modulated according to an NRZ-OOK modulation.

According to a particular embodiment, the electrostatic gate comprises at least first and second distinct parts which are decoupled one to the other, the first part of the electrostatic gate facing at least one first side of the semiconductor stack and being coupled to the output of the first driver circuit, and the second part of the electrostatic gate facing at least one second side of semiconductor stack, and the optoelectronic device further comprises:

- a second driver circuit comprising an input configured to receive a second part of the electrical digital information signal, and an output coupled to the second part of the electrostatic gate and onto which, for each bit of the second part of the electrical digital information signal, a voltage is supplied, the value of which depends at least in part on said bit;

- a third driver circuit comprising an input configured to receive a third part of the electrical digital information signal, and an output coupled to the second electrode and onto which, for each bit of the second part of the electrical digital information signal, a voltage is supplied, the value of which depends at least in part on that of said bit;

- an encoder configured to receive in an input the electrical digital information signal, to supply the first part of the electrical digital information signal to the input of the first driver circuit, to supply the second part of the electrical digital information signal to the input of the second driver circuit and to supply the third part of the electrical digital information signal to the input of the third driver.

According to a particular embodiment, the semiconductor stack further comprises a multiple quantum well structure arranged between the first and second doped semiconductor portions.

According to a particular embodiment, the first doped semiconductor portion is a part of a first doped semiconductor layer, the second doped semiconductor portion is a part of a second doped semiconductor layer and the multiple quantum well structure is a part of multiple quantum well layers, the optoelectronic device further comprises a trench passing through at least a part of the thickness of the first and second doped semiconductor layers and the multiple quantum well layers, and the electrostatic gate is arranged in the trench.

According to a particular embodiment, the electrostatic gate comprises a gate dielectric arranged against sidewalls of the trench and a gate conductor such that the gate dielectric is arranged between the sidewalls of the trench and the gate conductor.

According to a particular embodiment, the optoelectronic device comprises:

- several semiconductor stacks, each comprising parts of the first and second doped semiconductor layers and of the multiple quantum well layers;

- several first electrodes, each coupled to the first doped semiconductor portion of one of the semiconductor stacks;

- several second electrodes, each coupled to the second doped semiconductor portion of one of the semiconductor stacks;

- several electrostatic gates arranged in trenches, each passing through at least a part of the thickness of the first and second doped semiconductor layers and the multiple quantum well layers, each electrostatic gate being arranged in at least one of the trenches;

and the first electrodes are coupled one to the other.

According to a particular embodiment, the first conductivity type corresponds to P-type and the second conductivity type corresponds to N-type.

According to a particular embodiment, the first driver circuit is configured to output a negative voltage when a bit of the light digital information signal is intended to be outputted by the optoelectronic device with a highest optical power, and to output a positive voltage when a bit of the light digital information signal is intended to be outputted by the optoelectronic device with a lowest optical power.

Another embodiment proposes a method for producing an optoelectronic device configured to convert an electrical digital information signal into a light digital information signal, comprising at least:

- producing a semiconductor stack including at least a first doped semiconductor portion of a first conductivity type, and a second doped semiconductor portion of a second conductivity type forming, with the first doped semiconductor portion, a PN junction;

- producing a first electrode coupled to the first doped semiconductor portion, a second electrode coupled to the second doped semiconductor portion, and an electrostatic gate arranged against sidewalls of at least a part of the semiconductor stack;

- producing a first driver circuit comprising an input configured to receive at least a first part of the electrical digital information signal and an output coupled to the electrostatic gate and onto which, for each bit of the first part of the electrical digital information signal, a voltage is supplied, the value of which depends at least in part on that of said bit.

Brief description of drawings

The foregoing features and advantages, as well as others, will be described in detail in the following description of specific embodiments given by way of illustration and not limitation with reference to the accompanying drawings, in which:

- figure 1 schematically illustrates an example of a semiconductor structure of an optoelectronic device according to a particular embodiment;

- figure 2 schematically illustrates an optoelectronic device according to a first embodiment;

- figure 3 schematically illustrates an optoelectronic device according to a second embodiment;

- figure 4 schematically illustrates an optoelectronic device according to a third embodiment;

- figure 5, figure 6, figure 7, figure 8 and figure 9 show different steps of a method for producing a semiconductor structure of an optoelectronic device according to a particular embodiment.

Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, different elements (driver circuits, encoders, etc.) of the described optoelectronic devices have not been detailed. Detailed implementation of these elements is within the capabilities of those skilled in the art based on the functional description provided hereinabove.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements. In addition, in all the document, the words "coupled" and "decoupled" are used to designate an electrical coupling or decoupling between elements.

In all the document, the expression "μLED" is used to designate a μLED or a LED, whatever the dimensions of this device.

In all the document, the term "conductive" is used to designate an electrical conductivity. In addition, the term "insulating" is used to designate an electrical insulation.

Unless specified otherwise, the expressions "around", "approximately", "substantially" and "in the order of" signify within 10 %, and preferably within 5 %.

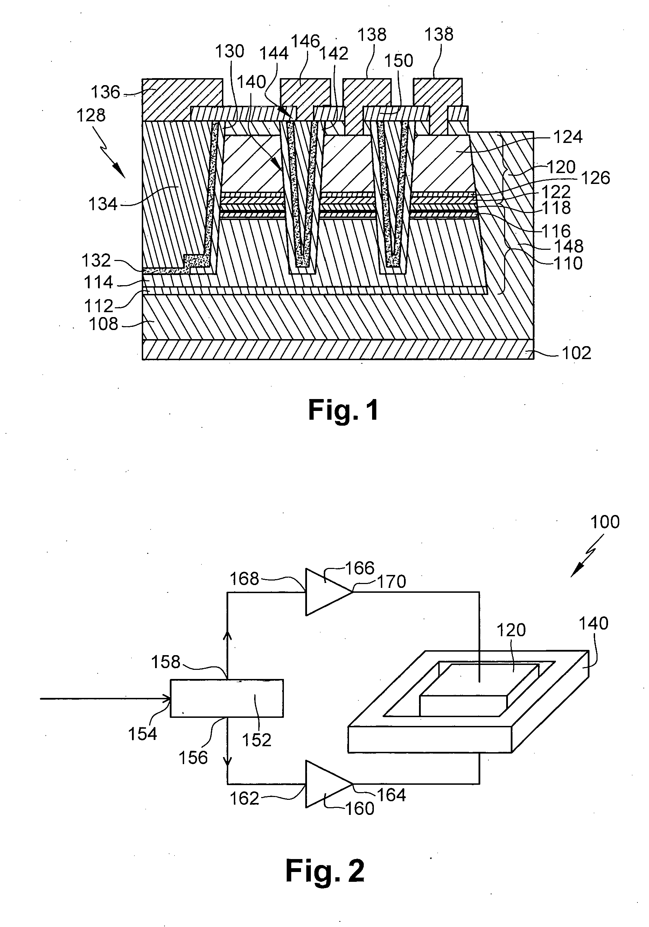

An example of a semiconductor structure of an optoelectronic device 100 is described below in relation with figure 1.

In the example shown on figure 1, the semiconductor structure comprises a substrate 102 forming a support onto which other elements of the semiconductor structure are arranged. For example, the substrate 102 may correspond to a bulk semiconductor substrate, e.g. a Si(100) wafer. As a variant, other types of substrate 102 may be used to form this support. It is also possible that the substrate 102 comprises previously produced electronic components, and may correspond for example to an integrated circuit such as an ASIC (Application-Specific Integrated Circuit). Particularly, the substrate 102 may comprise the electronic circuits (driver circuits, encoder) described below.

In the example shown in figure 1, the semiconductor structure also comprises a dielectric layer 108 forming an insulating layer between the substrate 102 and the elements arranged above the dielectric layer 108. For example, the dielectric layer 108 may comprise $SiO_2$, and the thickness of the dielectric layer 108 may be equal to 800 nm or more generally comprised between 500 nm and 1 um. As a variant, other types of dielectric layer 108 can be considered. For example, when the substrate 102 corresponds to an ASIC, the dielectric layer may include electrical vias that will ensure the connection between the ASIC and electrodes.

The semiconductor structure of the optoelectronic device 100 also comprises a first electrode 110. In the example shown in figure 1, the first electrode 110 comprises a stack of several metal portions 112, 114, 116 and 118. The metal portion 112 may comprise titanium nitride and a thickness between 5 nm and 30 nm, thus providing good adhesion, contact and diffusion barrier between the first electrode and the other elements against which the first electrode 110 is arranged (especially if the substrate 102 corresponds to an ASIC). The metal portion 114 may comprise titanium and a thickness between 400 nm and 1000 nm, thus providing low resistance electrode. The metal portion 116 may comprise titanium nitride TiN and a thickness between 10 nm and 40 nm, thus providing good contact, adhesion and diffusion barrier between titanium and the contact stack. The metal portion 118 may comprise aluminum, thus providing a metal contact with at least a first doped semiconductor portion 122. As a variant, the first electrode 110 may comprise a number of metal portions, or more generally conductive portions, different than in the example shown in figure 1, or even a single conductive material portion.

The optoelectronic device 100 also comprises a semiconductor stack 120 including the first doped semiconductor portion 122 of a first conductivity type, and a second doped semiconductor portion 124 of a second conductivity type opposite to the first conductivity type. The first and second doped semiconductor portions 122, 124 form together a PN junction. In the example shown in figure 1, the first and second doped semiconductor portions 122, 124 comprise GaN. As a variant, the first and second doped semiconductor portions 122, 124 may comprise other type of semiconductor, e.g. phosphides or arsenides. The thickness of the first doped semiconductor portion 122 may be between 100 nm and 200 nm and the thickness of the second doped semiconductor portion 124 may be between 500 nm and 1500 nm. For example, the total thickness of the semiconductor stack 120 may be equal to 1100 nm, or more generally comprised between 1000 nm and 2000 nm.

In the example shown in figure 1, the semiconductor stack 120 further comprises a multiple quantum well structure 126 arranged between the first and second doped semiconductor portions 122, 124. The multiple quantum well structure 126 may comprise several quantum well layers each arranged between barrier layers, i.e. may correspond to an alternating stack of quantum well layers and barrier layers. The semiconductors of the quantum well layers and the barrier layers of the multiple quantum well structure 126 are not intentionally doped and may be chosen to be compatible with those of the first and second doped semiconductor portions 122, 124. In the example here described, the semiconductor of the quantum well layers may comprise InGaN and the semiconductor of the barrier layers may comprise GaN. As a variant, the quantum well layers and/or the barrier layers may comprise other type of semiconductors. The thicknesses of each of the quantum well layers and of the barrier layers may be between 1 nm and 5 nm for the quantum well layers and between 10 nm and 20 nm for barrier layers, and the thickness of each quantum well structure may be between 20 nm and 100 nm.

As a variant, the semiconductor stack 120 may comprise a single quantum well structure arranged between the first and second doped semiconductor portions 122, 124. According to another variant, the first and second doped semiconductor portions 122, 124 may be arranged directly one against the other, i.e. without any quantum well structure between them.

In the example here described, the semiconductor stack 120 has a mesa shape.

The first electrode 110 is coupled to the first doped semiconductor portion 122. In the example shown in figure 1, the first doped semiconductor portion 122 is arranged above and in contact with the first electrode 110.

In the example shown in figure 1, the device 100 also comprises a first electrode contact 128 which is arranged in a hole or a trench made through the semiconductor stack 120 and a part of the thickness of the first electrode 110. In this example, the sidewalls of this hole or trench are covered by a dielectric layer 130 which may comprise aluminum oxide $Al_2O_3$, aluminum nitride, silicon oxide $SiO_2$ or silicon nitride and whose thickness may be between 40 nm and 100 nm. In this configuration, the dielectric layer 130 enables to insulate the first electrode contact 128 from the semiconductor stack 120. Because of the arrangement of the dielectric layer 130 against sidewalls of the hole or trench, the electrical contact between the first electrode contact 128 and the first electrode 110 is located at the bottom wall of the hole or trench. In the example shown in figure 1, the first electrode contact 128 comprises a first conductive layer 132 which may comprise aluminum or a stack of aluminum/Ti/TiN, and whose thickness may be between 80 nm and 120 nm, and a conductive metal portion 134, e.g. comprising copper, filling the rest of the volume of the hole or trench. In addition, the first electrode contact 128 also comprise a first conductive pad 136 which enables to electrically contact the first electrode contact 128 from the outside of the semiconductor structure if needed. The first conductive pad 136 may comprise aluminum. As a variant, the first electrode contact 128 may comprise other type of conductor elements or portions. As another variant, the first electrode contact 128 may be connected to the ASIC pads by cutting through the dielectric layer 108.

The device 100 also comprises a second electrode 138 coupled to the second doped semiconductor portion 124. In the example shown in figure 1, the second electrode 138 is arranged above and in contact with the second doped semiconductor portion 124. Moreover, in this example, the second electrode 138 forms a second conductive pad which can be electrically contacted from the outside of the semiconductor structure. In this configuration, the second electrode 138 may comprise the same conductive material as the first conductive pad 136. As a variant, other configurations are possible for the second electrode 138.

In the example here described, the first conductivity type of the first doped semiconductor portion 122 corresponds to P-type and the second conductivity type of the second doped semiconductor portion 124 corresponds to N-type. Thus, in this example, the first electrode 110 corresponds to the anode of the optoelectronic device 100 and the second electrode 138 corresponds to the cathode of the optoelectronic device 100. As a variant, the first electrode 110 may correspond to the cathode of the optoelectronic device 100 and the second electrode 138 may correspond to the anode of the optoelectronic device 100.

The semiconductor structure of the device 100 also comprises an electrostatic gate 140 arranged against sidewalls of at least a part of the semiconductor stack 120. In the example here described, the electrostatic gate 140 is arranged against sidewalls of the first and second doped semiconductor portions 122, 124 and also against sidewalls of the multiple quantum well structure 126. More generally, the electrostatic gate 140 may be arranged against sidewalls of at least part of the first doped semiconductor portion 122 and/or of the second doped semiconductor portion 124 and of the multiple quantum well structure 126 (to modulate the carriers inside the quantum wells). In the example shown in figure 1, the electrostatic gate 140 is also arranged through a part of the thickness of the first electrode 110.

In the example shown in figure 1, the electrostatic gate 140 comprises a gate dielectric 142 arranged against sidewalls of the semiconductor stack 120 and the first electrode 110, and a gate conductor 144 arranged against the gate dielectric 142 such that the gate dielectric 142 is arranged between the sidewalls of the semiconductor stack 120 and of the first electrode 110, and the gate conductor 144. Thus, the gate dielectric 142 enables to insulate the gate conductor 144 from the semiconductor stack 120 and the first electrode 110. In the example shown in figure 1, the gate conductor 144 may comprise the same materials as those of the first electrode contact 128, and the gate dielectric 142 may comprise the same material and the same thickness as those of the dielectric layer 130. In addition, in the example shown in figure 1, another conductive pad 146 is arranged on the electrostatic gate 140 and may comprise the same conductive material as the first conductive pad 136. As a variant, other configurations are possible for the electrostatic gate 140.

In the example shown in figure 1, the electrostatic gate 140 is arranged in trenches made through the semiconductor stack 120, i.e. such that parts of the semiconductor stack 120 are arranged against either side of the electrostatic gate 140. As a variant, the electrostatic gate 140 may be arranged such that it surrounds the semiconductor stack 120, especially in an array configuration.

In the example shown in figure 1, the device 100 also comprises insulating trenches 148 crossing the different layers from which the semiconductor stack 120 and the first electrode 110 are produced. In this example, the insulating trenches 148 extend from a top face of the semiconductor structure until the dielectric layer 108. For example, the insulating trenches may comprise $SiO_2$. The insulating trenches 148 may surrounds laterally the semiconductor stack 120.

In the example shown in figure 1, the semiconductor structure of the optoelectronic device 100 also comprises dielectric portions 150 arranged on the top face of the semiconductor structure and contributing to the insulation between the conductive elements arranged on the top face of the semiconductor structure.

In the above-described semiconductor structure forming a μLED, when electrons and holes (carriers) pass through the multiple quantum well structure 126, they get trapped in the quantum wells, where they recombine and emit either a photon (which results in light emission) or a phonon (non-radiative recombination). Due to the etching process which may be implemented when fabricating the semiconductor structure, there exist a high density of defects and dangling bonds at the semiconductor structure's edge, and these are non-radiative recombination sites, meaning that they result in electrons and holes recombining without emitting light, decreasing the pLED's efficiency and light output power.

Thanks to the electrostatic gate 140 arranged against sidewalls of the semiconductor stack 120, the electrostatic gate 140 can be used to create an electric field at these sidewalls, leading to either an increase or decrease in carrier density at these sidewalls according to the bias voltage applied on the electrostatic gate 140. For example, applying a positive bias voltage on the electrostatic gate 140 creates an electric field that will attract electrons to the sidewalls, increasing the number of electrons undergoing non-radiative recombination, and thus decreasing efficiency and optical power. The opposite happens when applying a negative bias voltage on the electrostatic gate 140 (pushes electrons, increases radiative recombinations, and thus increasing efficiency and optical power).

The semiconductor structure shown in figure 1 corresponds to an example and numerous variants of this semiconductor structure can be considered.

Figure 2 shows schematically the configuration of the device 100 in a first embodiment.

The device 100 is configured to convert an electrical digital information signal into a light digital information signal. In addition to the semiconductor structure previously described in relation with figure 1, the device 100 comprises, to implement this conversion, an encoder 152 configured to receive on an input 154 the electrical digital information signal. In this first embodiment, the encoder 152 comprises a first output 156 onto which a first part, i.e. some bits, of the electrical digital information signal is supplied and a second output 158 onto which a second part of the electrical digital information signal is supplied. In this first embodiment, the encoder 152 sends some bits of the electrical digital information signal on the first output 156 and the other bits of the electrical digital information signal on the second output 158.

The device 100 also includes a first driver circuit 160 comprising an input 162 configured to receive the first part of the electrical digital information signal, and an output 164 coupled to the electrostatic gate 140 and onto which, for each bit applied on its input 162, a voltage is supplied, the value of which depends at least in part on that of said bit. In this first embodiment, the device 100 also comprises a second driver 166 comprising an input 168 configured to receive the second part of electrical digital information signal and an output 170 coupled to the second electrode 138 and onto which, for each bit applied on its input 168, a voltage is supplied, the value of which depends at least in part on that of said bit.

Thus, in this first embodiment, the electrical digital information signal is split by the encoder 152 into two electrical digital signals each comprising some bits of the electrical digital information signal. For example, the encoder 152 may be configured to encode the first and second parts of the electrical digital information signal from the electrical digital information signal which may be coded according to a PAM-4 modulation. In a particular configuration, the encoder 152 may be configured to encode the first and second parts of electrical digital information signal such that the first part comprises the odd bits of the electrical digital information signal and that the second part comprises the even bits of the electrical digital information signal, or, inversely, such that the first part comprises the even bits of the electrical digital information signal and that the second part comprises the odd bits of the electrical digital information signal.

In this first embodiment, the light emission of the optoelectronic device 100 is modulated according to the level of the voltage applied between the anode and the cathode of the semiconductor structure of the device 100, but also according to the level of the voltage applied on the electrostatic gate 140. This modulation of the light emission of the optoelectronic device 100 is obtained because in this configuration, each of the signals obtained at the outputs 164, 170 of the first and second driver circuits 160, 166 may have two possible values, according to the value of the bits applied on their input 162, 168.

Thus, in this first embodiment, the light can be emitted by the optoelectronic device 100 according to one of four levels. For example, for a high optical power level obtained by applying a voltage $V_{bias} + V_{mod}$ between the anode and the cathode, it is possible to apply a negative bias voltage $-V_{gate}$ on the electrostatic gate 140 to increase the emitted optical power. Moreover, for a low optical power level obtained by applying a voltage $V_{bias} - V_{mod}$ between the anode and the cathode, it is possible to apply a positive bias voltage $+V_{gate}$ on the electrostatic gate 140 to decrease the emitted optical power. In this first embodiment, the level of the optical power emitted by the optoelectronic device 100 can be coded with two bits of the electrical digital information signal, a first one being sent on the input 162 of the first driver circuit 160 and a second one being sent on the input 168 of the second driver circuit 166. The corresponding voltages applied between the first and second electrodes 110, 138 and on the electrostatic gate 140 may be:

[Table 1]

| State | 11 | 10 | 01 | 00 |
|---|---|---|---|---|
| $V_{anode\_cathode}$ | $V_{bias} + V_{mod}$ | $V_{bias} + V_{mod}$ | $V_{bias} - V_{mod}$ | $V_{bias} - V_{mod}$ |
| $V_{gate}$ | $-V_{gate}$ | 0 | 0 | $+V_{gate}$ |

In the above example, the sign of the modulation voltage $V_{mod}$ applied between the anode and the cathode is defined according to the value of the second bit of the above mentioned four states (e.g. the bit '1' for the state '10'). In addition, a bias voltage is applied on the electrostatic gate 140 only to obtain the highest and the lowest optical power levels, with a negative bias voltage $-V_{gate}$ applied to obtain the highest optical power level among the four optical power levels and a positive bias voltage $+V_{gate}$ applied to obtain the lowest optical power level among the four optical power levels. For example, a logic circuit can be configured such that when two consecutive bits have same values ('11' or '00') it will allow the voltage to pass to the third electrode. The polarity of this voltage will depend on the bits, it will be negative in the case where the bits are 1 and positive when they are 0. When the two consecutive bits are not the same, no voltage should pass to the third electrode.

As a variant, instead of applying a zero-bias voltage on the electrostatic gate 140 for the states '01' and '10', it is possible to apply a positive bias voltage $+V_{gate}$ on the electrostatic gate 140 for the state '10' and a negative voltage $-V_{gate}$ for the '01' state. In this variant, the corresponding voltages applied between the anode and the cathode and on the electrostatic gate 140 may be:

[Table 2]

| State | 11 | 10 | 01 | 00 |
|---|---|---|---|---|
| $V_{anode\_cathode}$ | $V_{bias} + V_{mod}$ | $V_{bias} + V_{mod}$ | $V_{bias} - V_{mod}$ | $V_{bias} - V_{mod}$ |
| $V_{gate}$ | $-V_{gate}$ | $+V_{gate}$ | $-V_{gate}$ | $+V_{gate}$ |

For example, the bit that refers to the third electrode (i.e. the '0' in the state '10') should control the voltage applied to the third electrode (e.g. negative for '1' and positive for '0'). This could be done, for example, by having two voltage sources coupled to the third electrode circuit, one that has a direct path to the third electrode (+0.5 V for example) and one source (-1 V for example) that is connected to a transistor that in turn is connected to-the third electrode. When the transistor reads '0', it cuts the -1 V source and the electrode is biased at +0.5 V, while when the transistor reads '1', it allows the -1 V bias to pass to the third electrode and thus a -0.5 V will be applied to the third electrode.

The above variant enables to increase the SNR between the '11' and '10' states as well as between the '01' and '00' states, but with a decrease of the SNR between the '10' and '01' states and an increase of the power consumption of the device 100 (because there is always a bias voltage applied on the electrostatic gate 140 whatever the optical power level emitted by the device 100) as counterpart.

Other combinations of voltage levels applied between the anode and the cathode and/or on the electrostatic gate 140 are possible.

In the above examples previously described in relation with the first embodiment, the encoder 152 is configured to encode the first and second parts of the electrical digital information signal from an electrical digital information signal which can be coded and modulated according to a PAM-4 modulation. This configuration is equivalent to send two separate NRZ-OOK signals on the semiconductor structure, one between the anode and the cathode and one on the electrostatic gate 140. As a variant, the encoder 152 may be configured to encode the first and second parts of the electrical digital information signal from an electrical digital information signal which is coded and modulated according to an NRZ-OOK modulation. In this variant, the electrostatic gate 140 may be used to decrease the BER of the device 100 thanks to a higher SNR obtained between the two possible states of the electrical digital information signal. In this variant, the voltages applied between the anode and the cathode and on the electrostatic gate 140 may be:

[Table 3]

| State | 1 | 0 |
|---|---|---|
| $V_{anode\_cathode}$ | $V_{bias} + V_{mod}$ | $V_{bias} - V_{mod}$ |
| $V_{gate}$ | $-V_{gate}$ | $+V_{gate}$ |

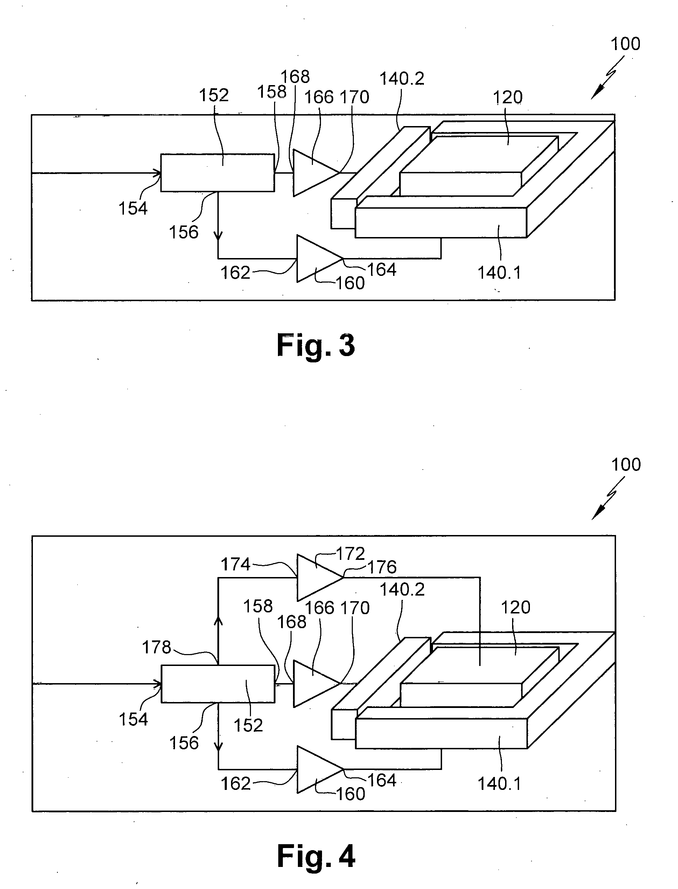

Figure 3 shows schematically the configuration of the optoelectronic device 100 according to a second embodiment. As in the first embodiment, the device 100 is configured to convert an electrical digital information signal into a light digital information signal. In this second embodiment, the electrostatic gate 140 comprises at least first and second distinct parts, referenced 140.1 and 140.2 on figure 3, which are decoupled one to the other. The first part 140.1 of the electrostatic gate 140 faces at least one first side of the semiconductor stack 120 and is coupled to the output 164 of the first driver circuit 160, and the second part 140.2 of the electrostatic gate 140 faces at least one second side of semiconductor stack 120 and is coupled to the output 170 of the second driver circuit 166.

Thus, in this second embodiment, the second driver circuit 166 comprises its input 168 configured to receive the second part of the electrical digital information signal and its output 170 coupled to the second part 140.2 of the electrostatic gate 140 and onto which, for each bit of the second part, a voltage is supplied, the value of which depends at least in part on that of said bit. The encoder 152 and the driver circuits 160, 166 may be similar to those previously described in relation with the first embodiment.

In this second embodiment, no modulation voltage is applied between the anode and the cathode of the semiconductor structure of the device 100, and only a bias voltage is applied between them in order to obtain a light emission from the semiconductor structure.

As in the first embodiment, the electrical digital information signal may be coded and modulated according to a PAM-4 modulation. Moreover, the behavior of the device 100 according to this second embodiment may be similar to that according to the first embodiment.

In this second embodiment, the level of the optical power emitted by the optoelectronic device 100 can be coded with two bits of the electrical digital information signal, and the corresponding voltages applied on the first part 140.1 of the electrostatic gate 140 ($V_{gate1}$) and on the second part 140.2 of the electrostatic gate 140 ($V_{gate2}$) may be:

[Table 4]

| State | 11 | 10 | 01 | 00 |
|---|---|---|---|---|
| $V_{gate1}$ | $-V_{gate1}$ | $-V_{gate1}$ | $+V_{gate1}$ | $+V_{gate1}$ |
| $V_{gate2}$ | $-V_{gate2}$ | 0 | 0 | $+V_{gate2}$ |

In the above example, the sign of the bias voltage $V_{gate1}$ applied on the first part 140.1 of the electrostatic gate 140 is defined according to the value of the second bit of the above mentioned four states. In addition, the bias voltage $V_{gate2}$ is applied on the second part 140.2 of the electrostatic gate 140 only to obtain the highest and the lowest optical power levels, with a negative bias voltage - $V_{gate2}$ applied to obtain the highest optical power level among the four optical power levels and a positive bias voltage $+V_{gate2}$ applied to obtain the lowest optical power level among the four optical power levels.

As a variant, instead of applying a zero-bias voltage on the second part 140.2 of the electrostatic gate 140 for the states '01' and '10', it is possible to apply a positive bias voltage $+V_{gate2}$ on the second part 140.2 of the electrostatic gate 140 for the state '10' and a negative bias voltage -$V_{gate2}$ for the '01' state. In this variant, the correspond voltages applied on the first and second parts 140.1, 140.2 of the electrostatic gate 140 may be:

[Table 5]

| State | 11 | 10 | 01 | 00 |
|---|---|---|---|---|
| $V_{gate1}$ | -$V_{gate1}$ | -$V_{gate1}$ | +$V_{gate1}$ | +$V_{gate1}$ |
| $V_{gate2}$ | -$V_{gate2}$ | +$V_{gate2}$ | -$V_{gate2}$ | +$V_{gate2}$ |

The above variant enables to increase the SNR between the '11' and '10' states as well as for the '01' and '00' sates, but with a decrease of the SNR between the '10' and '01' states and an increase of the power consumption of the device 100 (because there will always be a bias voltage applied on the second part 140.2 of the electrostatic gate 140 whatever the optical power level intended to be emitted by the device 100) as counterpart.

In the above examples previously described in relation with the second embodiment, the encoder 152 is configured to encode the first and second parts of the electrical digital information signal from the electrical digital information signal which is coded and modulated according to a PAM-4 modulation. As a variant, the encoder 152 may be configured to encode the first and second parts from an electrical digital information signal which is coded and modulated according to an NRZ-OOK modulation. In this variant, the electrostatic gate 140 may be used to decrease the BER of the device 100 thanks to a higher SNR obtained between the two possible states of the electrical digital information signal. In this variant, the voltages applied one the first and second parts 140.1, 140.2 of the electrostatic gate 140 may be:

[Table 6]

| State | 1 | 0 |
|---|---|---|
| $V_{gate1}$ | -$V_{gate1}$ | +$V_{gate1}$ |
| $V_{gate2}$ | -$V_{gate2}$ | +$V_{gate2}$ |

Figure 4 shows schematically the configuration of the device 100 according to a third embodiment. As in the first and second embodiments, the device 100 is configured to convert an electrical digital information signal into a light digital information signal. The device 100 according to the third embodiment combines the features previously disclosed for the first and second embodiments. Thus, in this third embodiment, the voltage applied between the anode and the cathode of the semiconductor structure is modulated according to optical power level intended to be emitted by the device 100, and the electrostatic gate 140 comprises the first and second distinct parts 140.1, 140.2 onto which modulated bias voltages are applied. The device 100 according to the third embodiment thus comprises:

- a semiconductor structure similar to that previously disclosed in relation with the second embodiment;

- a first driver circuit 160 similar to that previously disclosed in relation with the first and second embodiments;

- a second driver circuit 166 similar to that previously described in relation with the second embodiment;

- a third driver circuit 172 comprising an input 174 configured to receive a third part of the electrical digital information signal, and an output 176 coupled to the second electrode 138 and onto which, for each bit of this third part of the electrical digital information signal, a voltage is supplied, the value of which depends at least in part on that of said bit;

- the encoder 152 configured to receive on the input 154 the electrical digital information signal, to supply the first part of this signal to the input 162 of the first driver circuit 160, to supply the second part of this signal to the input 168 of the second driver circuit 166 and to supply the third part of this signal to the input 174 of the third driver circuit 172.

In this third embodiment, the encoder 152 comprises a third output 178 coupled to the input 174 of the third driver circuit 172.

The optoelectronic device 100 according to the third embodiment enables to use an electrical digital information signal coded and modulated according to a 8 levels modulation, e.g. PAM-8 modulation. This possibility is obtained thanks to the use of three separate modulated bias signals applied on the semiconductor structure, one between the anode and the cathode of the semiconductor structure, and one for each of the two parts 140.1, 140.2 of the electrostatic gate 140. In this configuration, the encoder 152 may be such that, for each group of three successive bits of the electrical digital information signal, one of these three bits is applied on the input 162 of the first driver circuit 160, a second one of these three bits is applied on the input 168 of the second driver circuit 166, and a third one of these three bits is applied on the input 174 of the third driver circuit 172.

In all examples and embodiments, the optoelectronic device 100 may comprise several semiconductor stacks 120 and electrostatic gates 140 forming several μLEDs and arranged to form a matrix of μLEDs. In this configuration, each semiconductor stack 120 and each electrostatic gate may be biased thanks to an encoder and driver circuits which are different or not for each μLED.

In all examples and embodiments, the first driver circuit 160 may be configured to output a negative voltage when a light data is intended to be outputted by the optoelectronic device 100 with a highest optical power, and to output a positive voltage when the light data is intended to be outputted by the optoelectronic device 100 with a lowest optical power.

In all examples and embodiments, the driver circuits of the optoelectronic device 100 may be configured to output a voltage the value of which can have two possible values or two states. However, it is possible to have one or several of the driver circuits of the optoelectronic device 100 which are configured to output voltage(s) which can have more that than two possible values, and to apply this or these voltage(s) on the electrostatic gate and/or on the semiconductor structure. In this configuration, the modulation of the bias voltage applied on the electrostatic gate enables to use an electrical digital information signal having more modulation levels.

The optoelectronic device 100 corresponds to a communication device configured to emit a digital light signal whose bits have values corresponding to that of bits of an input electrical signal, and in which the modulation of the emitted light power is controlled at least through the modulation of the bias voltage applied on the electrostatic gate 140.

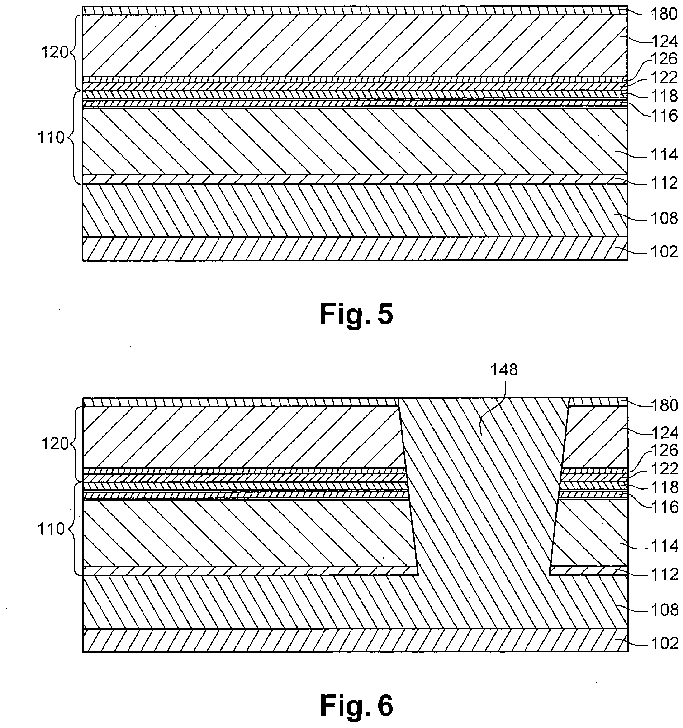

An example of a method for producing the semiconductor structure of the optoelectronic device 100 is disclosed below in relation with figures 5 to 9.

The steps of the method described below are carried out to produce collectively, on a signal support, several μLEDs which can be controlled independently one to the other. However, on figures 5 to 9, the production of the semiconductor structure of only one μLED of the optoelectronic device 100 is shown.

In a first step, the layers from which the semiconductor structure will be obtained may be produced, e.g. by epitaxy, on a temporary support which may correspond to conventional Si(111) wafer. The obtained structure is then flipped and the produced layers are bonded to the substrate 102. The initial temporary substrate used for the production of the layers is then removed (see the obtained structure shown in figure 5). For example, this first step is compatible with large-scale 200 mm industrial implementation.

In figure 5, the same references as those used to designate the different portions of the semiconductor structure previously disclosed in relation with figure 1 are used to designate the layers from which these portions are obtained.

A first etching is then carried out through the previously produced layers to form the insulating trenches 148. A hard mask layer 180 is produced on the layers intended to be etched before carrying out the etching. This hard mask layer 180 may comprise SiN and may have a thickness equal to 200 nm. The etched trenches are then filled with a dielectric material, e.g. $SiO_2$, to obtain the insulating trenches 148. If necessary, the dielectric material used to form the insulating trenches 148 and deposited above the hard mask layer 180 may be removed by a CMP (Chemical-Mechanical Planarisation, with a stop on the hard mask layer 180). The insulating trenches 148 enable to insulate the semiconductor structure of the different μLEDs produced from the obtained stack of layers, particularly to insulate the second doped semiconductor portion 138 of the different μLEDs from each other, and thus creating dielectric cavities between the μLEDs. The obtained structure at this stage of the method is shown in figure 6.

In the obtained structure, the first doped semiconductor portion 122 is a part of the first doped semiconductor layer, the second doped semiconductor portion 124 is a part of a second doped semiconductor layer and the multiple quantum well structure 126 is a part of multiple quantum well layers.

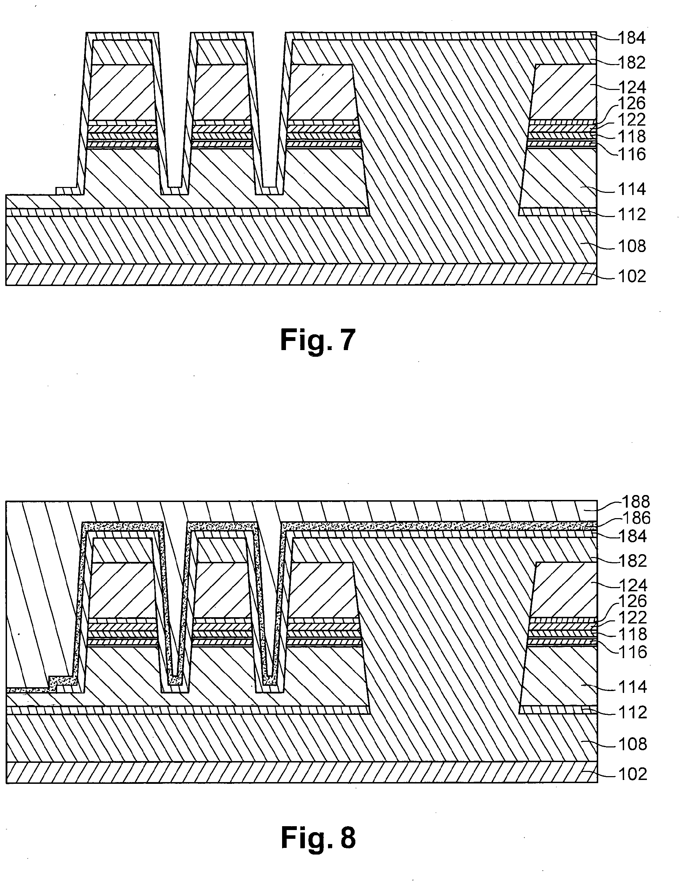

The hard mask 180 is removed and a second etching is then carried out to produce the trenches in which the first electrode contact 128 and the electrostatic gate 140 will be produced. As shown in figure 7, this etching is carried out through the layers of the semiconductor stack 120 and through a part of the thickness of the first electrode 110 (because in this example, the anode of several μLEDs arranged on the substrate 102 are intended to be coupled one to the other). Another hard mask used for this etching is shown in figure 7 and designated by the reference 182.

A dielectric layer 184 is then deposited on the obtained structure. In the example here described, the dielectric layer 184 is deposited to form a conformal layer covering the top face of the structure, the sidewalls of the previously etched trenches and the bottom walls of the trenches. In this example, the parts of the dielectric layer 184 arranged against sidewalls of the trench wherein the first electrode contact 128 will be produced are intended to form the dielectric layer 130, and the parts of the dielectric layer 184 arranged against sidewalls of the trenches wherein the electrostatic gate 140 will be produced are intended to form the gate dielectric 142.

After the deposition of the dielectric layer 184, the parts of the dielectric layer 184 arranged on the bottom wall of the trench wherein the first electrode contact 128 will be produced are etched in order to form an electrical access to the first electrode 110. The structure obtained at this stage of the method is shown in figure 7.

One or several conductive layers are then deposited to fill the previously etched trenches. In figure 8, a first conformal conductive layer 186 is deposited, and a conductive material 188 is then deposited to fill the remaining volumes of the trenches.

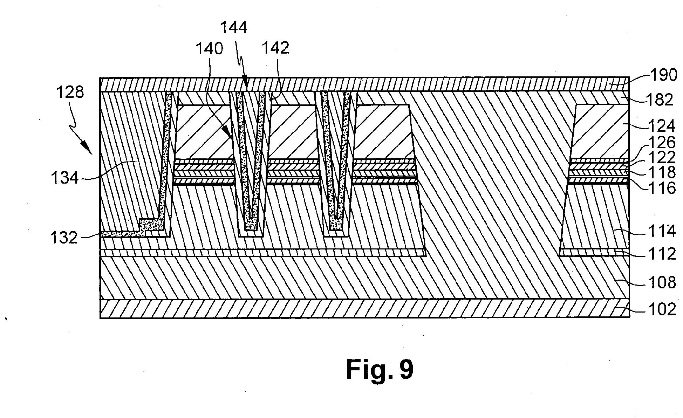

The parts of the conformal conductive material 186 and of the conductive material 188 arranged above the hard mask 182 are removed, e.g. with the implementation of a CMP with a stop on the hard mask 182. An insulating layer 190 intended to form the dielectric portions 150 is then deposited, as shown in figure 9.

The insulating layer 190 is then etched to form the dielectric portions 150, and the contact pads 136, 146 and the second electrode 138 are produced. The obtained structure corresponds to that shown in figure 1.

In the previously disclosed examples and embodiments, the anode is common to the μLEDs of the optoelectronic device 100 produced from the same stack of layers. As a variant, it is possible that the cathode corresponds to the common electrode of the μLEDs and that the anode corresponds to the electrode enabling an individual control of each pLED of the optoelectronic device 100. According to another variant, it is possible that none of the electrodes of the μLEDs is common to several μLEDs.

Thus, in the optoelectronic device 100, the electrostatic gate 140 is used to modulate the emitted optical power according to the value of the information intended to be transmitted.

In all examples and embodiment, the optoelectronic device 100 removes the need for a DAC or a linear driver even if the electrical digital information signal is coded and modulated on more than two levels, thus reducing power consumption and cost of the device. Moreover, the use of the electrostatic gate 140 for modulating the emitted optical power according to the information to be transmitted enables to decrease the required data rate from the optoelectronic device 100: for example, if the optoelectronic device 100 operates at 1 Gb/s, the direct modulation of the semiconductor stack 120 by the voltage applied between the anode and the cathode may be at 500 Mb/s, and the one carried out by the voltage applied on the electrostatic gate 140 may be at 500 Mb/s.

It is also possible to increase communication data rate (using higher order modulation) without a significant increase in circuit complexity (e.g. without the need of a DAC) .

In addition to the advantages previously mentioned, carrier recombination on the edge of the semiconductor stack 120 are faster than that in the bulk, so the modulation bandwidth of edge states, i.e. the modulation carried out by the electrostatic gate 140, should be higher compared to that of the semiconductor stack 120 carried out with the voltage applied between the anode and the cathode, thus improving the rise time and the SNR of the optoelectronic device 100. This effect can be used by implementing in the communication code a command that uses higher speed when transitioning between states involving different voltages applied on the electrostatic gate 140 compared to other transitions requiring modulating the semiconductor stack 120 itself.

The optoelectronic device 100 can be used for communication applications, with potentially a much faster commutation times than direct modulation of the semiconductor stack 120 alone.

In all examples and embodiments, the values of the voltages applied by the driver circuits on the semiconductor structure of the optoelectronic device 100 depend on the physical properties of the semiconductor structure, the use of the optoelectronic device 100, etc.

The optoelectronic device 100 may be used for all types of optical communications such that VLC, Li-Fi or UOWC, and advantageously for C2C optical communication.

Various embodiments and variants have been described. Those skilled in the art will understand that certain features of these embodiments can be combined and other variants will readily occur to those skilled in the art.

**Claims**

1. An optoelectronic device (100) configured to convert an electrical digital information signal into a light digital information signal, comprising at least:

   - a semiconductor stack (120) including at least a first doped semiconductor portion (122) of a first conductivity type and a second doped semiconductor portion (124) of a second conductivity type forming together a PN junction;
   - a first electrode (110) coupled to the first doped semiconductor portion (122), a second electrode (138) coupled to the second doped semiconductor portion (124), and an electrostatic gate (140) arranged against sidewalls of at least a part of the semiconductor stack (120) ;
   - a first driver circuit (160) comprising an input (162) configured to receive at least a first part of the electrical digital information signal and an output (164) coupled to the electrostatic gate (140) and onto which, for each bit of the first part of the electrical digital information signal, a voltage is supplied, the value of which depends at least in part on that of said bit.

2. The optoelectronic device (100) according to claim 1, further comprising:

- a second driver circuit (166) comprising an input (168) configured to receive a second part of the electrical digital information signal, and an output (170) coupled to the second electrode (138) and onto which, for each bit of the second part of the electrical digital information signal, a voltage is supplied, the value of which depends at least in part on that of said bit;
- an encoder (152) configured to receive in an input (154) the electrical digital information signal, to supply the first part of the electrical digital information signal to the input (162) of the first driver circuit (160) and to supply the second part of the electrical digital information signal to the input (168) of the second driver circuit (166).

3. The optoelectronic device (100) according to claim 1, wherein the electrostatic gate (140) comprises at least first and second distinct parts (140.1, 140.2) which are decoupled one to the other, the first part (140.1) of the electrostatic gate (140) facing at least one first side of the semiconductor stack (120) and being coupled to the output (164) of the first driver circuit (160), and the second part (140.2) of the electrostatic gate (140) facing at least one second side of semiconductor stack (120), and further comprising:

- a second driver circuit (166) comprising an input (168) configured to receive a second part of the electrical digital information signal, and an output (170) coupled to the second part (140.2) of the electrostatic gate (140) and onto which, for each bit of the second part of the electrical digital information signal, a voltage is supplied, the value of which depends at least in part on said bit;
- an encoder (152) configured to receive in an input (154) the electrical digital information signal, to supply the first part of the electrical digital information signal to the input (162) of the first driver circuit (160) and to supply the second part of the electrical digital information signal to the input (168) of the second driver circuit (166).

4. The optoelectronic device (100) according to one of claims 2 or 3, wherein the encoder (152) is configured to encode the first and second parts of electrical digital information signal such that said first part comprises the odd bits of the electrical digital information signal and that said second part comprises the even bits of the electrical digital information signal, or such that said first part comprises the even bits of the electrical digital information signal and that said second part comprises the odd bits of the electrical digital information signal.

5. The optoelectronic device (100) according to any one of claims 2 to 4, wherein the encoder (152) is configured to encode the first and second parts of the electrical digital information signal from the electrical digital information signal which is coded and modulated according to a PAM-4 modulation.

6. The optoelectronic device (100) according to any one of claims 2 to 4, wherein the encoder (152) is configured to encode the first and second parts of the electrical digital information signal from the electrical digital information signal which is coded and modulated according to an NRZ-OOK modulation.

7. The optoelectronic device (100) according to claim 1, wherein the electrostatic gate (140) comprises at least first and second distinct parts (140.1, 140.2) which are decoupled one to the other, the first part (140.1) of the electrostatic gate (140) facing at least one first side of the semiconductor stack (120) and being coupled to the output (164) of the first driver circuit (160), and the second part (140.2) of the electrostatic gate (140) facing at least one second side of semiconductor stack (120), and further comprising:

- a second driver circuit (166) comprising an input (168) configured to receive a second part of the electrical digital information signal, and an output (170) coupled to the second part (140.2) of the electrostatic gate (140) and onto which, for each bit of the second part of the electrical digital information signal, a voltage is supplied, the value of which depends at least in part on said bit;
- a third driver circuit (172) comprising an input (174) configured to receive a third part of the electrical digital information signal, and an output (176) coupled to the second electrode (138) and onto which, for each bit of the second part of the electrical digital information signal, a voltage is supplied, the value of which depends at least in part on that of said bit;
- an encoder (152) configured to receive in an input (154) the electrical digital information signal, to supply the first part of the electrical digital information signal to the input (162) of the first driver circuit (160), to supply the second part of the electrical digital information signal to the input (168) of the second driver circuit (166) and to supply the third part of the electrical digital information signal to the input (174) of the third driver (172).

8. The optoelectronic device (100) according to any one of preceding claims, wherein the semiconductor stack (120) further comprises a multiple quantum well structure (126) arranged between the first and second doped semiconductor portions (122, 124).

9. The optoelectronic device (100) according to claim 8, wherein the first doped semiconductor portion (122) is a part of a first doped semiconductor layer, the second doped semiconductor portion (124) is a part of a second doped semiconductor layer and the multiple quantum well structure (126) is a part of multiple quantum well layers, further comprising a trench passing through at least a part of the thickness of the first and second doped semiconductor layers and the multiple quantum well layers, and wherein the electrostatic gate (140) is arranged in the trench.

10. The optoelectronic device (100) according to claim 9, wherein the electrostatic gate (140) comprises a gate dielectric (142) arranged against sidewalls of the trench and a gate conductor (144) such that the gate dielectric (142) is arranged between the sidewalls of the trench and the gate conductor (144).

11. The optoelectronic device (100) according to any one of claims 9 or 10, comprising:

- several semiconductor stacks (120), each comprising parts of the first and second doped semiconductor layers and of the multiple quantum well layers;
- several first electrodes (110), each coupled to the first doped semiconductor portion (122) of one of the semiconductor stacks (120);
- several second electrodes (138), each coupled to the second doped semiconductor portion (124) of one of the semiconductor stacks (120);
- several electrostatic gates (140) arranged in trenches, each passing through at least a part of the thickness of the first and second doped semiconductor layers and the multiple quantum well layers, each electrostatic gate (140) being arranged in at least one of the trenches;

and wherein the first electrodes (110) are coupled one to the other.

12. The optoelectronic device (100) according to any one of previous claims, wherein the first conductivity type corresponds to P-type and the second conductivity type corresponds to N-type.

13. The optoelectronic device (100) according to any one of previous claims, wherein the first driver circuit (160) is configured to output a negative voltage when a bit of the light digital information signal is intended to be outputted by the optoelectronic device (100) with a highest optical power, and to output a positive voltage when a bit of the light digital information signal is intended to be outputted by the optoelectronic device (100) with a lowest optical power.

14. A method for producing an optoelectronic device (100) configured to convert an electrical digital information signal into a light digital information signal, comprising at least:

- producing a semiconductor stack (120) including at least a first doped semiconductor portion (122) of a first conductivity type, and a second doped semiconductor portion (124) of a second conductivity type forming, with the first doped semiconductor portion (122), a PN junction;
- producing a first electrode (110) coupled to the first doped semiconductor portion (122), a second electrode (138) coupled to the second doped semiconductor portion (124), and an electrostatic gate (140) arranged against sidewalls of at least a part of the semiconductor stack (120) ;
- producing a first driver circuit (160) comprising an input (162) configured to receive at least a first part of the electrical digital information signal and an output (164) coupled to the electrostatic gate (140) and onto which, for each bit of the first part of the electrical digital information signal, a voltage is supplied, the value of which depends at least in part on that of said bit.

**Fig. 1**

**Fig. 2**

**Fig. 3**

**Fig. 4**

**Fig. 5**

**Fig. 6**

**Fig. 7**

**Fig. 8**

**Fig. 9**

Europäisches
Patentamt

European
Patent Office

Office européen
des brevets

## EUROPEAN SEARCH REPORT

Application Number

EP 24 31 5158

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/278255 A1 (ZHANG YUEWEI [US] ET AL) 1 September 2022 (2022-09-01) * paragraph [0076] - paragraph [0088]; figures 13-15 * | 1-14 | INV. H04B10/116 H04B10/50 H01L27/15 H01L33/38 |
| X | US 2015/380461 A1 (ROBIN IVAN-CHRISTOPHE [FR] ET AL) 31 December 2015 (2015-12-31) * paragraph [0095] - paragraph [0111]; figures 1, 2 * * paragraph [0147] - paragraph [0154]; figures 10, 11 * | 1-14 | ADD. H01L33/20 H01L33/44 |
| A | WEI ZIXIAN ET AL: "Parallel Mini/Micro-LEDs Transmitter: Size-Dependent Effect and Gbps Multi-User Visible Light Communication", JOURNAL OF LIGHTWAVE TECHNOLOGY, IEEE, USA, vol. 40, no. 8, 28 December 2021 (2021-12-28), pages 2329-2340, XP011905479, ISSN: 0733-8724, DOI: 10.1109/JLT.2021.3138626 [retrieved on 2021-12-28] * page 2333, column 1, line 8 - line 32 * | 5,6 | |
| A | SHAO YINGJIE ET AL: "High-speed Optical Camera Communication Using a CMOS-driven Micro-LED Projector", 2022 IEEE PHOTONICS CONFERENCE (IPC), IEEE, 13 November 2022 (2022-11-13), pages 1-2, XP034247516, DOI: 10.1109/IPC53466.2022.9975751 [retrieved on 2022-12-14] * section II * | 5 | |

**TECHNICAL FIELDS SEARCHED (IPC)**

H04B
H01L

The present search report has been drawn up for all claims

| Place of search | Date of completion of the search | Examiner |
|---|---|---|
| The Hague | 18 September 2024 | Franssen, Gijs |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 31 5158

This annex lists the patent family members relating to the patent documents cited in the above-mentioned European search report.
The members are as contained in the European Patent Office EDP file on
The European Patent Office is in no way liable for these particulars which are merely given for the purpose of information.

18-09-2024

| Patent document cited in search report | Publication date | Patent family member(s) | Publication date |
|---|---|---|---|
| US 2022278255 A1 | 01-09-2022 | NONE | |
| US 2015380461 A1 | 31-12-2015 | EP 2960951 A1 | 30-12-2015 |
| | | FR 3023065 A1 | 01-01-2016 |
| | | JP 6914608 B2 | 04-08-2021 |
| | | JP 2016027637 A | 18-02-2016 |
| | | KR 20160001717 A | 06-01-2016 |
| | | US 2015380461 A1 | 31-12-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **A. SAMANI et al.** A silicon photonic PAM-4 modulator based on dual-parallel Mach-Zehnder interferometers. *IEEE Photonics J.*, 2016, vol. 8 (1), 1-10

- **L. DENIEL et al.** DAC-less PAM-4 generation in the O-band using a silicon Mach-Zehnder modulator. *Opt. Express*, 2019, vol. 27 (7), 9740